# EUROPEAN PATENT APPLICATION

(11) **EP 4 723 169 A1**
(43) Date of publication of application: **08.04.2026**
(21) Application number: 24830024.6
(22) Date of filing: 28.03.2024
(51) Int. Cl.: H01L 23/367, H01L 23/473

(54) **HEAT DISSIPATION DEVICE AND MANUFACTURING METHOD FOR HEAT DISSIPATION DEVICE**

(30) Priority: 27.06.2023 CN 202310775898
(71) Applicant: ZTE CORPORATION, Shenzhen, Guangdong 518057 (CN)
(72) Inventor: TAO, Cheng, Shenzhen, Guangdong 518057 (CN); LIU, Fan, Shenzhen, Guangdong 518057 (CN); YANG, Xiaoping, Shenzhen, Guangdong 518057 (CN); ZHANG, Yuantong, Shenzhen, Guangdong 518057 (CN); WEI, Jinjia, Shenzhen, Guangdong 518057 (CN); ZHANG, Yonghai, Shenzhen, Guangdong 518057 (CN)
(74) Representative: Ziebig Hengelhaupt Intellectual Property Attorneys Patentanwaltskanzlei PartGmbB
(86) International application number: PCT/CN2024/084330
(87) International publication number: WO 2025/001373

(57) **Abstract**

The present application discloses a heat dissipation device and a manufacturing method for a heat dissipation device. The heat dissipation device comprises: a cover body and a bottom plate assembly; the bottom plate assembly comprises a heat dissipation chamber, a plurality of thermally conductive members are arranged in a first area of the heat dissipation chamber at a first interval, and a plurality of thermally conductive members are arranged in a second area of the heat dissipation chamber at a second interval, wherein the first interval is smaller than the second interval; the cover body at least covers the heat dissipation chamber, and the cover body is provided with a liquid inlet and a liquid outlet which are communicated with the heat dissipation chamber; and when a chip is in a mounting state, the surface of the bottom plate assembly distant from the cover body is in contact with the chip, a third area of the chip corresponds to the first area, and a fourth area of the chip corresponds to the second area, wherein the temperature of the third area is higher than that of the fourth area.

## Description

### CROSS-REFERENCE TO RELATED APPLICATIONS

The present application is claims priority to Chinese Application No. 202310775898.9, filed with the Chinese Patent Office on June 27, 2023, with the title "HEAT DISSIPATION DEVICE AND MANUFACTURING METHOD FOR HEAT DISSIPATION DEVICE", the disclosure of which is hereby incorporated by reference in its entirety.

### TECHNICAL FIELD

The present application relates to the field of heat dissipation equipment, and particularly relates to a heat dissipation device and a manufacturing method for a heat dissipation device.

### BACKGROUND

Since their advent in the late 1950s, semiconductor integrated circuits have rapidly evolved toward smaller size, higher speed, and greater storage capacity. However, with the advent of the post-Moore era, the growth of transistor density in integrated circuits has slowed. In particular, in 5th-Generation Mobile Communication Technology (5G), the Internet of Things, high-performance computing, and other high-computing applications, engineers have begun exploring the use of multi-layer packaging technologies on larger chips to significantly increase computing power within limited space. This has placed higher demands on chip heat dissipation design. On this basis, with the advancement of complex packaging processes and the proposal of the concept of large and small cores, non-uniform heating chips have begun to emerge. These non-uniform heating chips can experience extremely high heat fluxes in certain areas, leading to localized hotspots.

However, most existing heat dissipation devices are based on conventional microchannel designs with uniform heat sources, which are less effective for dissipating non-uniform heating chips.

### SUMMARY

The present application discloses a heat dissipation device and a manufacturing method thereof, which can solve the problem of poor heat dissipation effect on non-uniform heating chips in related technologies.

To solve the above problem, the present application adopts the following technical solutions.

In the first aspect, an embodiment of the present application discloses a heat dissipation device, comprising: a cover body and a bottom plate assembly, wherein: the bottom plate assembly comprises a heat dissipation chamber, a plurality of thermally conductive members are arranged in a first area of the heat dissipation chamber at a first interval, and a plurality of thermally conductive members are arranged in a second area of the heat dissipation chamber at a second interval, wherein the first interval is smaller than the second interval; the cover body at least covers the heat dissipation chamber, and the cover body is provided with a liquid inlet and a liquid outlet which are communicated with the heat dissipation chamber; when a chip is in a mounting state, the surface of the bottom plate assembly distant from the cover body is in contact with the chip, a third area of the chip corresponds to the first area, and a fourth area of the chip corresponds to the second area, wherein the temperature of the third area is higher than that of the fourth area.

In the second aspect, an embodiment of the present application discloses a manufacturing method for a heat dissipation device, comprising: welding a cover body, a liquid separation plate, and a liquid jet plate in sequence to form a first body of the heat dissipation device; welding a frame plate and a bottom plate in sequence to form a second body of the heat dissipation device, wherein the frame plate is provided with a heat dissipation chamber; and welding the first body and the second body in sequence to form the heat dissipation device.

An embodiment of the present application provides a heat dissipation device, wherein thermally conductive members are arranged in a relatively dense manner in the first area of the heat dissipation chamber of the bottom plate assembly, and thermally conductive members are arranged in a relatively sparse manner in the second area of the heat dissipation chamber of the bottom plate assembly, the high-temperature area of the chip corresponds to the first area, and the low-temperature area of the chip corresponds to the second area. When the chip is dissipating heat, the liquid flows into the heat dissipation chamber through the liquid inlet opened on the cover body, and then the liquid in the heat dissipation chamber flows out through the liquid outlet opened on the cover body. It can achieve local high heat control of the chip while maintaining good temperature uniformity, thereby improving the heat dissipation effect for non-uniform heating chips. Furthermore, using the heat dissipation device provided in the present application to dissipate heat from the chip can eliminate thermal stress caused by local temperature differences in the chip, ensuring the service life of high-power large chips and the packaging life.

### BRIEF DESCRIPTION OF DRAWINGS

Fig. 1 is a schematic diagram of the structure of a heat dissipation device disclosed in an embodiment of the present application;
Fig. 2 is a schematic diagram of the structure of a bottom plate assembly disclosed in an embodiment of the present application;
Fig. 3 is a schematic diagram of the structure of a thermally conductive member disclosed in an embodiment of the present application;
Fig. 4 is a schematic diagram of the liquid flow direction of a liquid separation plate disclosed in an embodiment of the present application;
Fig. 5 is a schematic diagram of the structure of a liquid jet plate disclosed in an embodiment of the present application;
Fig. 6 is a cross-sectional view of a heat dissipation device disclosed in an embodiment of the present application;
Fig. 7 is a schematic diagram of the structure of a frame plate disclosed in an embodiment of the present application;
Fig. 8 is a flow chart of a manufacturing method for a heat dissipation device disclosed in an embodiment of the present application.

### DETAILED DESCRIPTION

The technical solutions in the embodiments of the present application will be described clearly below in conjunction with the drawings in the embodiments of the present application. Obviously, the described embodiments are part of the embodiments of the present application, not all of them. Based on the embodiments in the present application, all other embodiments obtained by those skilled in the art belong to the protection scope of the present application.

The terms "first", "second", etc. in the specification and claims of the present application are used to distinguish similar objects, and are not used to describe a specific order or sequence. It should be understood that data used in this way can be interchangeable where appropriate, so that the embodiments of the present application can be implemented in an order other than those illustrated or described here, and the objects distinguished by "first", "second", etc. are generally of one type, and the number of objects is not limited. For example, the first object can be one or more. In addition, "and/or" in the specification and claims represents at least one of the connected objects, and the character "/" generally indicates that the objects associated with each other are in an "or" relationship.

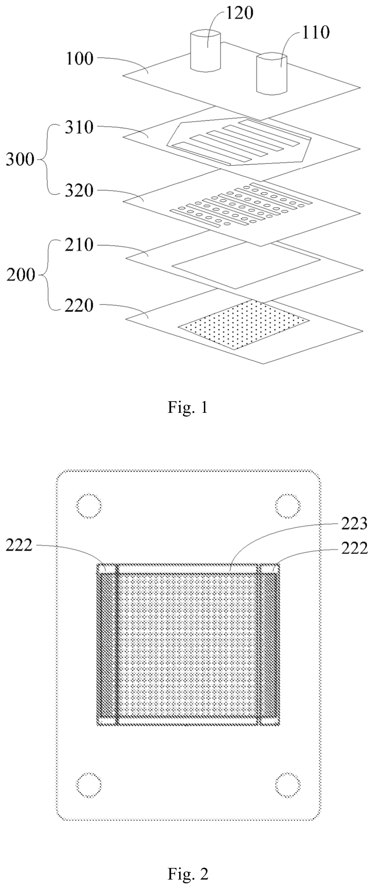

The present application discloses a heat dissipation device and a manufacturing method for a heat dissipation device. Fig. 1 is a schematic diagram of the structure of a heat dissipation device disclosed in an embodiment of the present application, and Fig. 2 is a schematic diagram of the structure of a bottom plate assembly disclosed in an embodiment of the present application.

As shown in Fig. 1 and Fig. 2, the heat dissipation device disclosed in the present application comprises: a cover body 100 and a bottom plate assembly 200, wherein: the bottom plate assembly 200 comprises a heat dissipation chamber 211, a plurality of thermally conductive members 221 are arranged in a first area 222 of the heat dissipation chamber 211 at a first interval, and a plurality of thermally conductive members 221 are arranged in a second area 223 of the heat dissipation chamber 211 at a second interval, wherein the first interval is smaller than the second interval; the cover body 100 at least covers the heat dissipation chamber 211, and the cover body 100 is provided with a liquid inlet 110 and a liquid outlet 120 which are communicated with the heat dissipation chamber 211; when a chip is in a mounting state, the surface of the bottom plate assembly 200 distant from the cover body 100 is in contact with the chip, a third area of the chip corresponds to the first area 222, and a fourth area of the chip corresponds to the second area 223, wherein the temperature of the third area is higher than that of the fourth area.

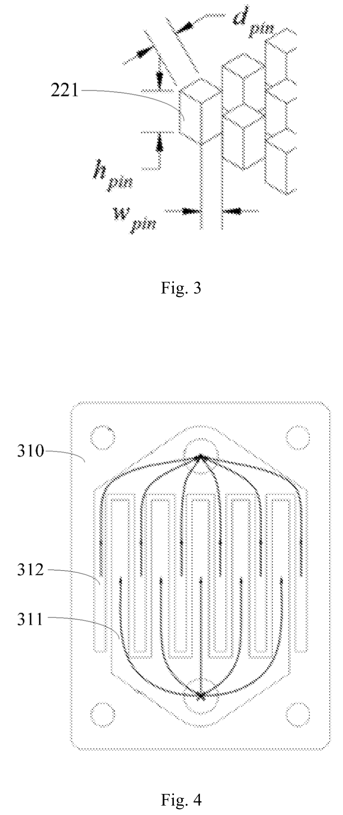

It should be noted that the height of the thermally conductive member 221 is less than that of the heat dissipation chamber 211. For example, as shown in Fig. 3, the height hₚᵢₙ of the thermally conductive member 221 can be 0.7 to 0.8 times the height of the heat dissipation chamber 211. Furthermore, the thickness of the cover body 100 can be 300-500 µm, and the diameters of the liquid inlet 110 and the liquid outlet 120 can be 5-8 mm.

With the heat dissipation device disclosed in the present application, liquid enters the heat dissipation chamber 211 through the liquid inlet 110 opened on the cover body 100, and heat conduction is carried out by contact between the thermally conductive member 221 and the liquid in the heat dissipation chamber 211, thereby achieving heat dissipation of the chip arranged under the bottom plate assembly 200, and then the liquid in the heat dissipation chamber 211 flows out through the liquid outlet 120 opened on the cover body 100.

In a solution disclosed in the present application, the thermally conductive members 221 are arranged in a relatively dense manner in the first area 222 of the bottom plate assembly 200, where the first area corresponds to the high heat flux density area of the chip, that is, the surface area of the thermally conductive member 221 in contact with the liquid in the first area 222 is relatively large, and the thermally conductive members 221 are arranged in a relatively sparse manner in the second area 223 of the bottom plate assembly 200, where the second area corresponds to the low heat flux density area of the chip, that is, the surface area of the thermally conductive member 221 in contact with the liquid in the second area 223 is relatively small. This can achieve local high heat control of the chip while maintaining good temperature uniformity, thereby improving the heat dissipation effect of the non-uniform heating chip.

An embodiment of the present application provides a heat dissipation device, wherein thermally conductive members 221 are arranged in a relatively dense manner in the first area 222 of the heat dissipation chamber 211 of the bottom plate assembly 200, and thermally conductive members 221 are arranged in a relatively sparse manner in the second area 223 of the heat dissipation chamber 211 of the bottom plate assembly 200, the high-temperature area of the chip corresponds to the first area 222, and the low-temperature area of the chip corresponds to the second area 223. When the chip is dissipating heat, the liquid flows into the heat dissipation chamber 211 through the liquid inlet 110 opened on the cover body 100, and then the liquid in the heat dissipation chamber 211 flows out through the liquid outlet 120 opened on the cover body 100. It can achieve local high heat control of the chip while maintaining good temperature uniformity, thereby improving the heat dissipation effect for non-uniform heating chips. Furthermore, using the heat dissipation device provided in the present application to dissipate heat from the chip can eliminate thermal stress caused by local temperature differences in the chip, ensuring the service life of high-power large chips and the packaging life.

In the present application, the thermally conductive member 221 can be a microneedle tooth. Using microneedle tooth as the thermally conductive member 221 can effectively enhance the overall heat transfer effect, avoid the occurrence of local hot spots, and achieve better temperature control in high heat flux density areas. It should be noted that the microneedle tooth can be a rectangular columnar structure, which is not specifically limited in the present application.

In one implementation, when the thermally conductive members 221 are rectangular columnar structures, the spacing between the thermally conductive members 221 can be equal to the width of the bottom surface of the rectangular columnar structure. In other words, the bottom surface width of the thermally conductive member 221 disposed in the first area 222 is smaller than the bottom surface width of the thermally conductive member 221 disposed in the second area 223. When the thermally conductive members 221 are square columnar structures, the spacing length between the thermally conductive members 221 can be equal to the side length of the bottom square of the square columnar structure, that is, the bottom square of the thermally conductive member 221 disposed in the first area 222 is smaller than the bottom square of the thermally conductive member 221 disposed in the second area 223. For example, as shown in Fig. 3, the side length dₚᵢₙ of the bottom square of the thermally conductive member 221 disposed in the first area 222 can be 150-300um, the first spacing wₚᵢₙ can be 150-300um, the side length dₚᵢₙ of the bottom square of the thermally conductive member 221 disposed in the second area 223 can be 300-500um, and the second spacing wₚᵢₙ can be 300-500um. In addition, the height of the thermally conductive members 221 arranged in the first area 222 and the height of the thermally conductive members 221 arranged in the second area 223 can be set according to actual heat dissipation requirements. For example, the height of the thermally conductive member 221 arranged in the first area 222 is set to be greater than the height of the thermally conductive member 221 arranged in the second area 223.

In an embodiment of the present application, as shown in Fig. 1, the heat dissipation device may further comprise a flow equalization assembly 300, the flow equalization assembly 300 comprises a plurality of flow equalization channels 311 and a plurality of drainage channels 312, the flow equalization channels 311 and the drainage channels 312 are arranged alternately, the flow equalization channels 311 are communicated with the liquid inlet 110, the flow equalization channels 311 are provided with a plurality of liquid outlet holes 321 spaced apart, the liquid outlet holes 321 are communicated with the flow equalization channels 311 and the heat dissipation chamber 211, and the plurality of drainage channels 312 are communicated with the liquid outlet 120 and the heat dissipation chamber 211.

The plurality of flow equalization channels 311 and the plurality of drainage channels 312 on the flow equalization assembly 300 can be arranged alternately along a preset direction of the flow equalization assembly 300. For example, along the preset direction of the flow equalization assembly 300, they are arranged in the order: drainage channels 312 numbered 1, 3 and 5, and flow equalization channels 311 numbered 2, 4 and 6, respectively. The liquid outlet holes 321 can be arranged in a single row or multiple rows along the flow equalization channels 311. For example, the diameter of the liquid outlet holes 321 can be 0.8-1.2 mm, and the spacing between the liquid outlet holes 321 can be 2.5-4 mm.

When dissipating heat from the chip, the liquid flows into multiple flow equalization channels 311 on the flow equalization assembly 300 through the liquid inlet 110 opened on the cover body 100. After the liquid flows uniformly in each flow equalization channel 311, it vertically impacts into the heat dissipation chamber 211 with the thermally conductive member 221 through the liquid outlet holes 321, completing the distributed jet to dissipate heat from the chip. Then the liquid flows out through the drainage channels 312 and the liquid outlet 120. The design of the liquid outlets 321 adopted in the present application can increase the flow rate of the liquid flowing downward, thereby increasing disturbance and enhancing heat exchange. The heat dissipation chamber 211 can provide a mixed flow space, extend the jet path, and enhance the heat dissipation effect.

The heat dissipation device disclosed in the present application improves overall heat exchange, reduces flow resistance, and enhances temperature uniformity by adding a flow equalization assembly 300 between the cover body 100 and the bottom plate assembly 200.

In one implementation, the drainage channels 312 can be strip-shaped drainage frames, thereby increasing the outflow speed of the liquid.

In an embodiment of the present application, the flow equalization assembly 300 can comprise a liquid separation plate 310 and a liquid jet plate 320, the liquid separation plate 310 comprises the plurality of flow equalization channels 311 and the plurality of drainage channels 312, the liquid jet plate 320 comprises a plurality of the liquid outlet holes 321 and a plurality of drainage frames 322, the liquid outlet holes 321 correspond to the flow equalization channels 311, the drainage frames 322 correspond to the drainage channels 312, and the drainage frames 322 are communicated with the drainage channels 312 and the heat dissipation chamber 211.

In the present application, the flow equalization assembly 300 can be composed of a liquid separation plate 310 and a liquid jet plate 320. The liquid flow direction in the liquid separation plate 310 is shown in Fig. 4. The liquid separation plate 310 comprises a plurality of flow equalization channels 311 and a plurality of drainage channels 312. The plurality of flow equalization channels 311 and the plurality of drainage channels 312 can be arranged alternately along a preset direction of the liquid separation plate 310. For example, along the preset direction of the liquid separation plate 310, they are arranged in the order: drainage channels numbered 1, 3 and 5, and flow equalization channels 311 numbered 2, 4 and 6, respectively. For example, the liquid separation plate 310 can have a thickness of 1-1.5 mm. The plurality of flow equalization channels 311 can have a rake-shaped structure, and the plurality of drainage channels 312 can also have a rake-shaped structure. The width of the flow equalization channel 311 can be 1-1.5 mm, and the width of the drainage channel 312 can be 1-1.5 mm.

In one implementation, the liquid separation plate 310 can further comprise a liquid inlet collection chamber and a liquid outlet collection chamber. The liquid inlet collection chamber is communicated with the plurality of flow equalization channels 311, and the liquid outlet collection chamber is communicated with the drainage channels 312. The liquid flowing in through the liquid inlet 110 flows through the liquid inlet collection chamber and the flow equalization channels 311 in sequence, and the liquid flowing out through the drainage channels 312 and the liquid outlet collection chamber in sequence, and then flows out from the liquid outlet 120.

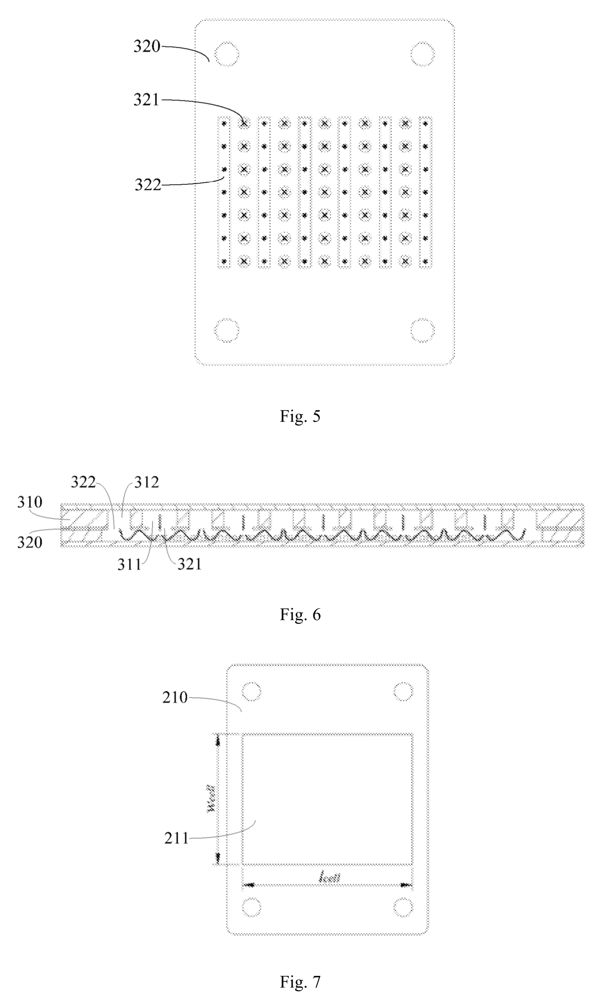

The structure of the liquid jet plate 320 is shown in Fig. 5. The liquid jet plate 320 comprises a plurality of liquid outlet holes 321 and a plurality of drainage frames 322. Along the preset direction of the liquid jet plate 320, they are arranged in the order: drainage frames 322 numbered 1, 3 and 5, and liquid outlet holes 321 numbered 2, 4 and 6, respectively. It should be noted that the preset direction of the liquid jet plate 320 is the same as the preset direction of the liquid separation plate 310. The drainage frames 322 correspond to the drainage channels 312, and the liquid outlets 321 correspond to the flow equalization channels 311. For example, the thickness of the liquid jet plate 320 can be 300-500µm, the drainage frames 322 can be strip-shaped square frames, the length of the drainage frames 322 can be 20-35mm, and the width of the drainage frames 322 can be 1-1.5mm.

Fig. 6 is a cross-sectional view of the heat dissipation device. When the chip is dissipating heat, the liquid flows into the multiple flow equalization channels 311 on the liquid separation plate 310 through the liquid inlet 110 opened on the cover body 100. After the liquid flows uniformly in each flow equalization channel 311, it vertically impacts the heat dissipation chamber 211 with the thermally conductive member 221 through the liquid outlet 321, completing the distributed jet to dissipate heat from the chip. Then, the liquid flows through the drainage frames 322 and the drainage channels 312 in sequence and flows out from the liquid outlet 120.

In an embodiment of the present application, the arrangement area of the flow equalization channels 311 and the liquid discharge channels 312 can be larger than the arrangement area of the thermally conductive members 221 on the bottom plate assembly 200, thereby enabling more uniform heat dissipation for the chip.

In one implementation, the bottom plate assembly 200 can comprise a frame plate 210 and a bottom plate 220, as shown in Fig. 7. The frame plate 210 is provided with the heat dissipation chamber 211. A plurality of thermally conductive members 221 are arranged in the first area 222 of the bottom plate 220 at the first interval, and a plurality of thermally conductive members 221 are arranged in the second area 223 of the bottom plate 220 at the second interval. It should be noted that the positions of the first area 222 and the second area 223 shown in Fig. 2 are only an example, and the present application does not specifically limit the specific arrangement of the first area 222 and the second area 223.

For example, the thickness of the frame plate 210 can be 600-1500 µm. Accordingly, the height of the heat dissipation chamber 211 can be 600-1500 µm. The length l_{cell} of the heat dissipation chamber 211 can be 35-40 mm, the width w_{cell} of the heat dissipation chamber 211 can be 30-35 mm, and the thickness of the bottom plate 220 can be 400-600 µm.

In one implementation, the area of the thermally conductive members 221 on the bottom plate assembly 200 is larger than the area of the chip, thereby achieving better heat dissipation from the chip.

Due to the high thermal conductivity and low cost of copper, the entire material of the heat dissipation device can be red copper.

Encapsulating the heat dissipation device and chip as a whole enables embedded cooling of the chipset, reducing interfacial thermal resistance. Since the chip is silicon-based, diffusion-heat welding between the chip and the heat dissipation device presents interface reliability risks due to the mismatch in the thermal expansion coefficients of copper and silicon. To address this, in the present application, the heat dissipation device can further comprise a metal transition layer disposed between the bottom plate assembly 200 and the chip. The present application utilizes a metal transition layer to separate the bottom plate assembly 200 from the chip, addressing the interface reliability risks associated with the mismatch in thermal expansion coefficients between copper and silicon.

In one implementation, this metal transition layer can be formed by performing a TI/NI-Pt-Au sputtering metallization on the surface of the bottom plate assembly 200 proximal to the chip. Furthermore, the temperature of the diffusion heat soldering process between the chip and the heat dissipation device can reduced, minimizing the impact on the chip's performance.

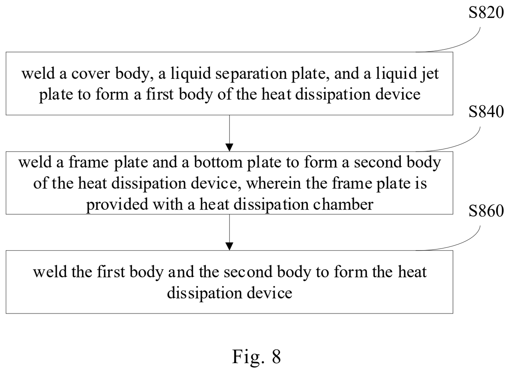

The present application also discloses a manufacturing method for a heat dissipation device, as shown in Fig. 8. The manufacturing method comprises:
S820: a cover body 100, a liquid separation plate 310, and a liquid jet plate 320 are welded to form a first body of the heat dissipation device.
S840: a frame plate 210 and a bottom plate 220 are welded to form a second body of the heat dissipation device, wherein the frame plate 210 is provided with a heat dissipation chamber 211.
S860: the first body and the second body are welded to form the heat dissipation device.

According to the manufacturing method disclosed in the present application, firstly the cover body 100, the liquid separation plate 310, and the liquid jet plate 320 are sequentially joined by diffusion welding to form the first body of the heat dissipation device. Then, the frame plate 210 and the bottom plate 220 are sequentially joined by diffusion welding to form the second body of the heat dissipation device. Finally, the first main body and the second main body are sequentially joined by diffusion welding or solder welding to form the heat dissipation device. Since the pressure required for diffusion welding of the first body and the second body is lower than that required for the five-layer integrated diffusion welding of the cover body 100, the liquid separation plate 310, the liquid jet plate 320, the frame plate 210, and the bottom plate 220, it is possible to reduce the possibility of collapse of the heat dissipation chamber 211. Moreover, there is no pressure when the first body and the second body are welded by solder, so there will be no problem of uneven force on the heat dissipation chamber 211 leading to its collapse. In addition, the manufacturing method for a heat dissipation device disclosed in the present application can also avoid the phenomenon of liquid channeling between the liquid separation plate 310 and the liquid jet plate 320 caused by misalignment.

After soldering the heat dissipation device, it is reduced using hydrogen or a nitrogen-hydrogen mixture to prevent oxidation.

Also, the surface of the bottom plate 220 distant from the frame plate 210 can be nano-processed to make it smoother. Furthermore, the surface of the bottom plate 220 distant from the frame plate 210 can be metallized using TI/NI-Pt-Au sputtering to separate the bottom plate 220 from the chip and address interface reliability risks caused by the mismatch in thermal expansion coefficients between copper and silicon.

In the present application, the cover body 100, liquid separation plate 310, liquid jet plate 320, frame plate 210, and bottom plate 220 are processed separately. For example, the bottom plate 220, on which the thermally conductive members 221 are arranged, can be processed using Computer number control (CNC), cutting, or etching. The cover body 100, liquid separation plate 310, and frame plate 210 can be processed using CNC, and the liquid jet plate 320 can be processed using etching.

The above embodiments of the present application focus on the differences between the various embodiments. As long as the optimized features of the various embodiments do not conflict, they can be combined to form a more optimized embodiment. For the sake of brevity, these details will not be repeated here.

The above descriptions are merely examples of the present application and are not intended to limit the present application. For those skilled in the art, the present application may have various modifications and changes. Any modification, equivalent replacement, improvement, etc. made within the spirit and principles of the present application shall be included in the scope of the claims of the present application.

## Claims

1. A heat dissipation device, comprising: a cover body and a bottom plate assembly, wherein:
the bottom plate assembly comprises a heat dissipation chamber, a plurality of thermally conductive members are arranged in a first area of the heat dissipation chamber at a first interval, and a plurality of thermally conductive members are arranged in a second area of the heat dissipation chamber at a second interval, wherein the first interval is smaller than the second interval;
the cover body at least covers the heat dissipation chamber, and the cover body is provided with a liquid inlet and a liquid outlet which are communicated with the heat dissipation chamber;
when a chip is in a mounting state, the surface of the bottom plate assembly distant from the cover body is in contact with the chip, a third area of the chip corresponds to the first area, and a fourth area of the chip corresponds to the second area, wherein the temperature of the third area is higher than that of the fourth area.

2. The heat dissipation device according to claim 1, further comprising a flow equalization assembly, wherein the flow equalization assembly comprises a plurality of flow equalization channels and a plurality of drainage channels, the flow equalization channels and the drainage channels are arranged alternately, the flow equalization channels are communicated with the liquid inlet, the flow equalization channels are provided with a plurality of liquid outlet holes spaced apart, the liquid outlet holes are communicated with the flow equalization channels and the heat dissipation chamber, and the plurality of drainage channels are communicated with the liquid outlet and the heat dissipation chamber.

3. The heat dissipation device according to claim 2, wherein the drainage channels are strip-shaped drainage frames.

4. The heat dissipation device according to claim 2, wherein the flow equalization assembly comprises a liquid separation plate and a liquid jet plate, the liquid separation plate comprises the plurality of flow equalization channels and the plurality of drainage channels, the liquid jet plate comprises a plurality of the liquid outlet holes and a plurality of drainage frames, the liquid outlet holes correspond to the flow equalization channels, the drainage frames correspond to the drainage channels, and the drainage frames are communicated with the drainage channels and the heat dissipation chamber.

5. The heat dissipation device according to claim 2, wherein the arrangement area of the flow equalization channels and the drainage channels is larger than the arrangement area of the thermally conductive members on the bottom plate assembly.

6. The heat dissipation device according to claim 1, wherein the bottom plate assembly comprises a frame plate and a bottom plate, the frame plate is provided with the heat dissipation chamber, a plurality of thermally conductive members are arranged in the first area of the bottom plate at the first interval, and a plurality of thermally conductive members are arranged in the second area of the bottom plate at the second interval.

7. The heat dissipation device according to claim 1, wherein the area of the thermally conductive member on the bottom plate assembly is larger than that of the chip.

8. The heat dissipation device according to claim 1, further comprising a metal transition layer disposed between the bottom plate assembly and the chip.

9. A manufacturing method for a heat dissipation device, comprising:
welding a cover body, a liquid separation plate, and a liquid jet plate to form a first body of the heat dissipation device;
welding a frame plate and a bottom plate to form a second body of the heat dissipation device, wherein the frame plate is provided with a heat dissipation chamber;
welding the first body and the second body to form the heat dissipation device.

10. The manufacturing method according to claim 9, further comprising:
performing nano-processing and metallization processing on a surface of the bottom plate distant from the frame plate.
